# EUROPÄISCHE PATENTSCHRIFT

(11) **EP 0 866 373 B1**
(45) Veröffentlichungstag und Bekanntmachung des Hinweises auf die Patenterteilung: **05.06.2002**
(21) Anmeldenummer: 98104902.6
(22) Anmeldetag: 18.03.1998
(51) Int. Cl.: G03F 7/09

(54) **Verfahren zum Herstellen eines lichtempfindlichen Aufzeichnungsmaterials**
Process for forming a light-sensitive recording material
Procédé pour la formation d'un matériau d'enregistrement photosensible

(30) Priorität: 20.03.1997 DE 19711696
(43) Veröffentlichungstag der Anmeldung: 23.09.1998
(73) Patentinhaber: BASF Drucksysteme GmbH, 48165 Münster (DE)
(72) Erfinder: Telser, Thomas, Dr., 69469 Weinheim (DE); Wegener, Stefan, Dr., 55124 Mainz (DE); Philipp, Sabine, Dr., 64546 Moerfelden-Walldorf (DE); Zürger, Manfred, 74889 Sinsheim (DE)
(74) Vertreter: Isenbruck, Günter, Dr.

(56) Entgegenhaltungen:
- EP-A- 0 231 112
- EP-A- 0 681 221
- EP-A- 0 753 415
- DE-A- 3 825 782
- US-A- 5 069 999
- PATENT ABSTRACTS OF JAPAN vol. 17, no. 526 (P-1617), 21.September 1993 & JP 05 142777 A (HITACHI CHEM. CO., LTD.)

## Beschreibung

Die Erfindung betrifft ein Verfahren zum Herstellen eines lichtempfindlichen, insbesondere photopolymerisierbaren Aufzeichnungsmaterials, vor allem für die Herstellung von Reliefdruckplatten, zum Beispiel von Flexodruckplatten, das aus einem dimensionsbeständigen Schichtträger beziehungsweise einer Trägerfolie, gegebenenfalls einer Haftschicht, mindestens einer lichtempfindlichen, insbesondere photopolymerisierbaren Schicht, einer nicht lichtempfindlichen Deckschicht und einer abtrennbaren Schutzfolie aufgebaut ist. Die verschiedenen Schichten werden auf den Schichtträger oder die Schutzfolie in geeigneter Weise, zum Beispiel durch Beschichten mit einer Lösung der Bestandteile und Trocknen, durch Aufbringen einer Schmelze oder durch Laminieren unter Druck und gegebenenfalls Erwärmen aufgebracht.

Bei der Herstellung von Hochdruckplatten ist es üblich, die Bestandteile der lichtempfindlichen Schicht in einem geeigneten Lösemittel zu lösen und die Lösung auf einen vorgefertigten Verbund aus Schutzfolie und Deckschicht aufzugießen. Nach dem Trocknen der lichtempfindlichen Schicht wird der Verbund schließlich mit einer mit einem Haftlack beschichteten Trägerfolie durch Kaschieren verbunden.

Bei der Herstellung von Flexodruckplatten ist es üblich, die Bestandteile der lichtempfindlichen Schicht in einem Extruder aufzuschmelzen und zu durchmischen. Die Schmelze wird dann durch eine Breitschlitzdüse ausgetragen und in den Spalt eines Kalanders eingetragen. Über die eine Walze des Kalanders wird die mit Deckschicht beschichtete Schutzfolie, über die zweite Walze des Kalanders die mit Haftlack beschichtete Trägerfolie eingefahren. Im Spalt des Kalanders wird die lichtempfindliche Schmelze mit den Verbundelementen Schutzfolie/Deckschicht und Haftlack/Trägerfolie verbunden.

Bei der Verarbeitung der Druckplatte muß die Schutzfolie abgezogen werden, ohne daß dabei die darunter liegenden Schichten aus ihrem Verbund gelöst werden. Insbesondere muß die Deckschicht vollständig auf der lichtempfindlichen Schicht verbleiben. Wenn bei der bevorzugten Ausführungsform des Herstellungsverfahrens die Deckschicht zunächst aus Lösung auf die Schutzfolie aufgebracht und getrocknet und der Schichtverbund dann mit der aufgeschmolzenen, lichtempfindlichen Schicht durch Kalandrieren vereinigt wird, entstehen häufig beim Abziehen der Schutzfolie von der Deckschicht Haftungsprobleme, da die Deckschicht auf der Schutzfolie in manchen Fällen besser haftet als auf der lichtempfindlichen Schicht.

Für eine gute Verarbeitbarkeit der Druckplatte muß aber eine zuverlässig reproduzierbare Haftungsdifferenz zwischen Deckschicht und lichtempfindlicher Schicht einerseits und Deckschicht und Schutzfolie andererseits bestehen. Das gleiche gilt für Schichtverbunde, die zum Beispiel zusätzliche Schichten enthalten. Derartige Materialien sind zum Beispiel in den EP-A 84 851 und 456 336 beschrieben. Hier werden die zusätzlichen Schichten separat hergestellt und dann durch Laminieren oder Kalandrieren mit dem übrigen Schichtverbund vereinigt. Wenn hier die Haftung zwischen den lichtempfindlichen Schichten ungenügend ist, so führt dies beim Auswaschen, insbesondere in Bereichen mit feinen Reliefteilen, zu Bildfehlern, die schlecht oder gar nicht druckende Klischees ergeben.

Aufgabe der Erfindung war es, ein Verfahren zur Herstellung eines lichtempfindlichen Aufzeichnungsmaterials, insbesondere für die Herstellung von Reliefdruckplatten, vorzuschlagen, das mehrschichtige Druckplatten liefert, deren Schichten untereinander und zu Schichtträgern und zu Schutzfolien eine gezielt und reproduzierbar einstellbare Haftung aufweisen, so daß es möglich ist, Teile des mehrschichtigen Materials, insbesondere temporäre Schutzfolien, zuverlässig abzutrennen, ohne daß eine unbeabsichtigte Trennung an anderer Stelle, das heißt zwischen anderen Schichten erfolgt.

Erfindungsgemäß wird ein Verfahren zum Herstellen eines photopolymerisierbaren Aufzeichnungsmaterials für die Herstellung von Reliefdruckplatten vorgeschlagen, bei dem eine lichtempfindliche Schicht mit einem Verbundelement aus einer abtrennbaren Schutzfolie, einer Deckschicht und gegebenenfalls einer weiteren Schicht verbunden wird. Das erfindungsgemäße Verfahren ist dadurch gekennzeichnet, daß die lichtempfindliche schicht als Schmelze aufgebracht und die Oberfläche der obersten Schicht des Verbundelements 1 bis 3000 sekunden vor dem Kontaktieren einer Coronabehandlung unterworfen wird.

Eine Coronabehandlung ist on sich aus dem stand der Technik bekannt, insbesondere aus der DE-A-3 825 782 und der EP-A-681 221.

Durch diese Behandlung wird die Haftung zwischen der Deckschicht und der lichtempfindlichen Schicht wesentlich und so gleichmäßig erhöht, daß beim Abziehen der Schutzfolie von der Deckschicht die letztere vollständig und fehlerfrei an der darunterliegenden Schicht haften bleibt.

Wenn eine Druckplatte, insbesondere eine Flexodruckplatte, hergestellt werden soll, die mehr als eine lichtempfindliche Schicht enthält, so kann das oben erwähnte Verbundelement auf der nicht lichtempfindlichen Deckschicht noch eine lichtempfindliche Schicht tragen. Diese Schicht muß nicht von Anbeginn her lichtempfindlich sein; es reicht aus, wenn zunächst eine Schicht aufgebracht wird, die nur ein polymeres Bindemittel, aber keine polymerisierbare Verbindung und keinen Photoinitiator enthält. Bei der Lagerung der Platte, bei der diese Schicht in Kontakt mit der anderen lichtempfindlichen Schicht steht, können deren niedermolekulare Bestandteile, wie polymerisierbare Verbindungen und Photoinitiatoren, in die Polymerschicht diffundieren und diese ebenfalls lichtempfindlich machen.

Wenn eine derartige Schicht vorgesehen ist, wird sie in der Regel als Lösung auf die Deckschicht aufgebracht und getrocknet. Dabei sind naturgemäß die Bestandteile der Deckschicht und das Lösemittel der zusätzlichen Schicht so zu wählen, daß die Deckschicht nicht oder nur wenig angelöst wird. Es ist auch möglich, die zusätzliche Schicht aus einer Dispersion in einem Lösemittel, zum Beispiel Wasser, aufzubringen, in dem die Deckschicht unlöslich ist. Die zusätzliche Schicht hat im allgemeinen eine Dicke von etwa 20 bis 200 µm. Auch kann die zusätzliche Schicht, wenn sie eine bestimmte Mindestdicke, zum Beispiel etwa 50 µm aufweist, aus der Schmelze durch Extrudieren und Kalandrieren aufgebracht werden. Vor dem Aufbringen der zusätzlichen Schicht kann auch die Oberfläche der Deckschicht erfindungsgemäß durch Corona behandelt werden, insbesondere wenn die zusätzliche Schicht durch Kalandrieren aufgebracht wird.

Die Coronabehandlung erfolgt unmittelbar vor dem Aufbringen der Schicht, also etwa innerhalb von 1 bis 3000, vorzugsweise von etwa 60 bis 600 Sekunden vor diesem Schritt. Dies läßt sich im großtechnischen Maßstab besonders vorteilhaft im Rahmen eines kontinuierlichen Herstellungsverfahrens erreichen, bei dem das zu beschichtende Band vor der Beschichtungsstation beziehungsweise vor dem Einlaufen in den Kalanderspalt eine Coronastation passiert, bei dem die Coronabehandlung also "inline" erfolgt.

Auf dem Schichtträger, der normalerweise dauerhaft mit den darauf befindlichen Schichten verbunden bleibt, kann unterhalb der lichtempfindlichen Schicht noch eine dünne Haftschicht vorgesehen sein.

Die lichtempfindliche Schicht beziehungsweise die lichtempfindlichen Schichten arbeiten normalerweise negativ, das heißt sie werden durch Belichtung gehärtet. Dies kann durch Photovernetzung von vorgefertigten Polymeren oder durch Photopolymerisation von niedermolekularen polymerisierbaren Verbindungen erfolgen. Photopolymerisierbare Schichten enthalten im wesentlichen ein polymeres, im Entwickler auswaschbares Bindemittel, eine ethylenisch ungesättigte, radikalisch polymerisierbare Verbindung und eine durch aktinische Strahlung, insbesondere langwelliges ultraviolettes oder kurzwelliges sichtbares Licht, aktivierbaren Polymerisationsinitiator. Die Zusammensetzung solcher Schichten ist bekannt und zum Beispiel in der DE-A 24 56 439, den EP-A 84 851 und 456 336 oder der US-A 4 072 527 beschrieben. Mit besonderem Vorteil werden als Bindemittel Elastomere, zum Beispiel Block-Copolymerisate mit starren Polymerblöcken, zum Beispiel aus Styrol-, Acrylnitril- oder Acrylestereinheiten und elastischen Blöcken aus Dienpolymerisaten, zum Beispiel von Butadien oder Isopren, eingesetzt.

Als polymerisierbare Verbindungen werden im allgemeinen solche mit endständigen ethylenisch ungesättigten Gruppen eingesetzt, besonders solchen, die durch benachbarte polare Gruppen, zum Beispiel Carbonyl-, Carboxyl-, Ester- oder Carbonsäureamidgruppen aktiviert sind. Besonders bevorzugt werden Ester und Amide der Acryl- oder Methacrylsäure.

Als Photoinitiatoren werden die für photopolymerisierbare Gemische üblichen Verbindungen eingesetzt. Beispiele sind in den vorstehend genannten Druckschriften angegeben.

Die Schicht kann ferner übliche Zusätze enthalten, zum Beispiel Inhibitoren für die thermische Polymerisation, Farbstoffe, photochrome Substanzen, Antioxydantien oder Weichmacher.

Die photopolymerisierbaren Schichten enthalten im allgemeinen 60 bis 95, bevorzugt 70 bis 95 Gew.-% Bindemittel, 5 bis 40, bevorzugt 5 bis 30 Gew.-% polymerisierbare Verbindungen und 0,01 bis 10, bevorzugt 0,1 bis 5 Gew.-% Photoinitiator, bezogen auf die Gesamtmenge von Bindemittel und polymerisierbaren Verbindungen. Sie haben im allgemeinen eine Dicke von 50 bis 7000, vorzugsweise von 200 bis 3000 µm.

Die Deckschicht, die auf die Schutzfolie aufgebracht wird, hat die Aufgabe, die Klebrigkeit der Druckplattenoberfläche zu beseitigen und die Handhabung der Platte beim Kontaktkopieren zu erleichtern. Sie hat zumeist eine Dicke von 0,1 bis 10 µm. Als Deckschichtmaterialien kommen Polyamide, Ethylen-Vinylacetat-Copolymere, teilverseifte Polyvinylacetate und andere thermoplastische Polymere in Betracht. Die Deckschicht sollte im Entwickler löslich sein.

Auf den Schichtträger wird häufig in bekannter Weise zur besseren Verankerung der lichtempfindlichen Schicht eine dünne Haftschicht, zum Beispiel aus einem handelsüblichen Ein- oder Zweikomponentenkleber, aufgebracht.

Diese Schicht hat im allgemeinen eine Dicke von 0,5 bis 30, bevorzugt 1 bis 10 µm und kann aus Klebern auf Polyurethan- oder Polychloroprenbasis bestehen.

Der Schichtträger ist zumeist eine flexible, dimensionsbeständige Folie, zum Beispiel aus Metall oder Kunststoff. Als Kunststofffolien sind unter anderem Polyesterfolien, zum Beispiel aus Polyethylenterephthalat, geeignet, die bevorzugt biaxial verstreckt und thermofixiert sind. Die Dicke der Folie liegt im allgemeinen im Bereich von 50 bis 300, vorzugsweise 75 bis 200 µm.

Die Schutzfolie kann aus dem gleichen Material wie der Schichtträger beziehungsweise die Trägerfolie bestehen. Wenn die Kontaktbelichtung der Druckplatte durch die Schutzfolie hindurch erfolgt, muß diese transparent sein. Sie hat gewöhnlich eine Dicke im gleichen Bereich wie die Trägerfolie, kann aber auch dünner als diese sein.

Zur Herstellung der lichtempfindlichen Druckplatte wird vorzugsweise zunächst eine Trägerfolie mit einer Haftlackschicht versehen und dann mit einer lichtempfindlichen Schicht beschichtet. Die Beschichtung erfolgt häufig aus einer Lösung, die dann zur festen Schicht getrocknet wird. Sie kann auch aus der Schmelze erfolgen, indem das lichtempfindliche Gemisch im Extruder aufgeschmolzen und homogenisiert und dann durch eine Breitschlitzdüse ausgetragen und in den Spalt eines Kalanders eingeführt wird. Die weiche bis viskose Masse wird dort mit der mit Haftlack grundierten Trägerfolie vereinigt. Zugleich kann von der gegenüberliegenden Seite der lichtempfindlichen Schicht die mit der Deckschicht beschichtete Schutzfolie zugeführt und damit vereinigt werden. Vor der Vereinigung der beiden Schichten wird die Schutzfolie mit der aufgebrachten Deckschicht unter einer Coronastation hindurchgeführt. Wenn auf die Deckschicht eine zusätzliche lichtempfindliche Schicht aufgebracht wird, kann die Deckschicht ebenfalls zuvor einer Coronabehandlung unterworfen werden, jedenfalls aber dann, wenn die zusätzliche Schicht durch Kalandrieren aufgebracht wird. In diesem Fall ist vor beiden Kalandrierschritten eine Coronabehandlung vorzunehmen. Auch kann bei Bedarf die Oberfläche der Trägerfolie beziehungsweise der darauf aufgebrachten Haftlackschicht vor dem Aufbringen beziehungsweise der Vereinigung mit der lichtempfindlichen Schicht einer Coronabehandlung unterworfen werden.

Die Verarbeitung der so hergestellten Druckplatte erfolgt in bekannter Weise. Die lichtempfindliche Schicht wird durch Kontaktbelichtung unter einer Transparentvorlage bebildert, wobei die Belichtung durch die Schutzfolie hindurch oder - nach Abziehen dieser Folie - nur durch die Deckschicht hindurch erfolgt. Die belichtete Druckplatte wird durch Auswaschen entwickkelt, wobei die Deckschicht und die unbelichteten Bereiche der lichtempfindlichen Schicht(en) entfernt werden. Als Entwickler sind je nach der Natur der lichtempfindlichen Schicht, vor allem ihres Bindemittels, organische Lösemittel, Gemische von Wasser und organischen Lösemitteln oder wäßrige Lösungen, zum Beispiel wäßrig-alkalische Lösungen, geeignet.

Es werden in jedem Fall punktgenaue Kopien der Vorlage erhalten, da sich die Schutzfolie leicht und ohne Beschädigung der Deckschicht von dieser abziehen läßt.

Die Wirksamkeit der erfindungsgemäßen Coronabehandlung ist davon abhängig, daß die nächste Schicht auf die coronabehandelte Oberfläche unverzüglich aufgebracht wird. Wenn die Schicht mit der coronabehandelten Oberfläche eine Zeit lang gelagert und erst dann mit der neuen Schicht versehen wird, wird nur eine geringfügige oder gar keine Verbesserung der Haftung erreicht. Überraschenderweise ist die Haftungsverbesserung unabhängig davon, ob die darauf folgende Beschichtung aus Lösung, aus der Schmelze oder durch Kaschieren oder Kalandrieren erfolgt. Insbesondere wird die haftungsverbessernde Wirkung der Coronabehandlung nicht dadurch beeinträchtigt, daß die coronabehandelte Schicht, zum Beispiel beim Kalandrieren, erweicht oder sogar aufschmilzt.

Die Erfindung wird in den folgenden Beispielen beschrieben, in denen Mengen- und Prozentangaben in Gewichtseinheiten zu verstehen sind, wenn nichts anderes angegeben ist.

### Beispiel 1

Eine 125 µm dicke Polyethylenterephthalat-Schutzfolie vom Typ Lumirror® X 43 (Toray Industries, Inc.) wurde mit einer Deckschicht aus Polyamid (Makromelt® 6900; Henkel KG a.A.) in einer Schichtdicke von 5 µm beschichtet und aufgewickelt.

| | |
|---|---|
| Ein lichtempfindliches | Gemisch aus |
| 80 T | Styrol-Isopren-Styrol-Block-Copolymeren (Kraton® D 1107; Shell Oil Co.) |
| 5 T | Hexandioldimethacrylat, |
| 5 T | Hexandioldiacrylat, |
| 7 T | Paraffinöl (Weißöl S 5000), |
| 1 T | Paraffinwachs, |
| 1 T | Benzildimethylketal, |
| 1 T | 2,6-Di-tert.-butyl-p-kresol und |
| 0,006 T | Sudanschwarz (C.I. 26 150) |

wurde in einem Zweischneckenextruder (ZSK 53) mit einem Durchsatz von 30 kg/h bei einer Massetemperatur von 130°C extrudiert und durch eine Breitschlitzdüse ausgetragen. Die aus der Düse ausgetragene Schmelze wurde in den Spalt eines Zweiwalzenkalanders eingeführt. Beide Walzen des Kalanders waren beheizt. Die Temperatur der Walzen lag bei 80°C. Über die obere Kalanderwalze wurde eine mit Haftlack beschichtete 125 µm dicke Polyethylenterephthalatfolie (Mylar®) eingeführt, über die untere Kalanderwalze die mit der Deckschicht aus Polyamid beschichtete Schutzfolie. Sobald die Schutzfolie Kontakt mit der Kalanderwalze bekam, schmolz die Deckschicht aus Polyamid; die Oberfläche wurde klebrig. Im Spalt des Kalanders wurden dann Trägerfolien mit Haftlack, lichtempfindliche Schmelze und Schutzfolie mit Deckschicht miteinander verbunden. Der Verbund wurde auf einem Saugband abgezogen, abgekühlt und konfektioniert.

Zwischen der Zuführeinrichtung für die Schutzfolie und dem Kalander wurde eine Coronabehandlungsstation der Fa. Kalwar installiert. Die Coronabehandlungsstation hatte eine Leistung von 3 KW. Es wurden Metallelektroden eingesetzt. Die zu behandelnde Schutzfolie einschließlich Deckschicht wurde über eine Gummiwalze an den Elektroden im Abstand von ca. 1 mm vorbeigeführt. Die Folienbreite betrug 50 cm, die Bahngeschwindigkeit betrug 60 cm/min. Die Stromstärke der Coronabehandlung wurde von 0 mA über 100 mA bis 200 mA variiert. Die Schutzfolie wurde abgewickelt. Die Deckschichtseite der Folie wurde dann coronabehandelt. Anschließend wurde die Folie zweimal umgelenkt (einmal mit Kontakt der Deckschicht zur Umlenkwalze) und auf die Kalanderwalze geführt.

An den hergestellten Druckplatten wurden Haftungsmessungen vorgenommen. Bestimmt wurde die Haftung der Schutzfolie zur Deckschicht und die Haftung der Deckschicht zur lichtempfindlichen Schicht.

Parameter der Haftungsmessungen: Zwick Zug-Dehnungsprüfmaschine, Abzugswinkel 90°, Abzuggeschwindigkeit 100 mm/min, Breite der Probe 2 cm.

Bei der Bestimmung der Haftung der Deckschicht zur lichtempfindlichen Schicht wurden die Proben wie folgt präpariert:

Die Schutzfolie wurde vom Probestreifen abgezogen. Auf ein Ende des Streifens wurde ein Stück Klebeband aufgebracht. Das Klebeband wurde vorsichtig zusammen mit der Deckschicht abgezogen und konnte dann in die Zug-Dehnungsmaschine eingespannt werden.

Die Haftungsmessungen wurden nach 1 und 4 Wochen wiederholt. Die Ergebnisse sind in Tabelle 1 zusammengefaßt. Die Werte sind in N/2 cm Breite angegeben.

Parallel zu den Haftungsmessungen wurde das Abziehen der Schutzfolie im Praxistest untersucht. Hierbei wurde von einem 30 x 40 cm großen Plattenstück die Schutzfolie von allen 4 Ecken abgezogen. Löste sich die Deckschicht an einer Ecke um mehr als 1 cm mit ab, wurde dies als negatives Prüfergebnis (Ablösung: "ja") festgehalten.

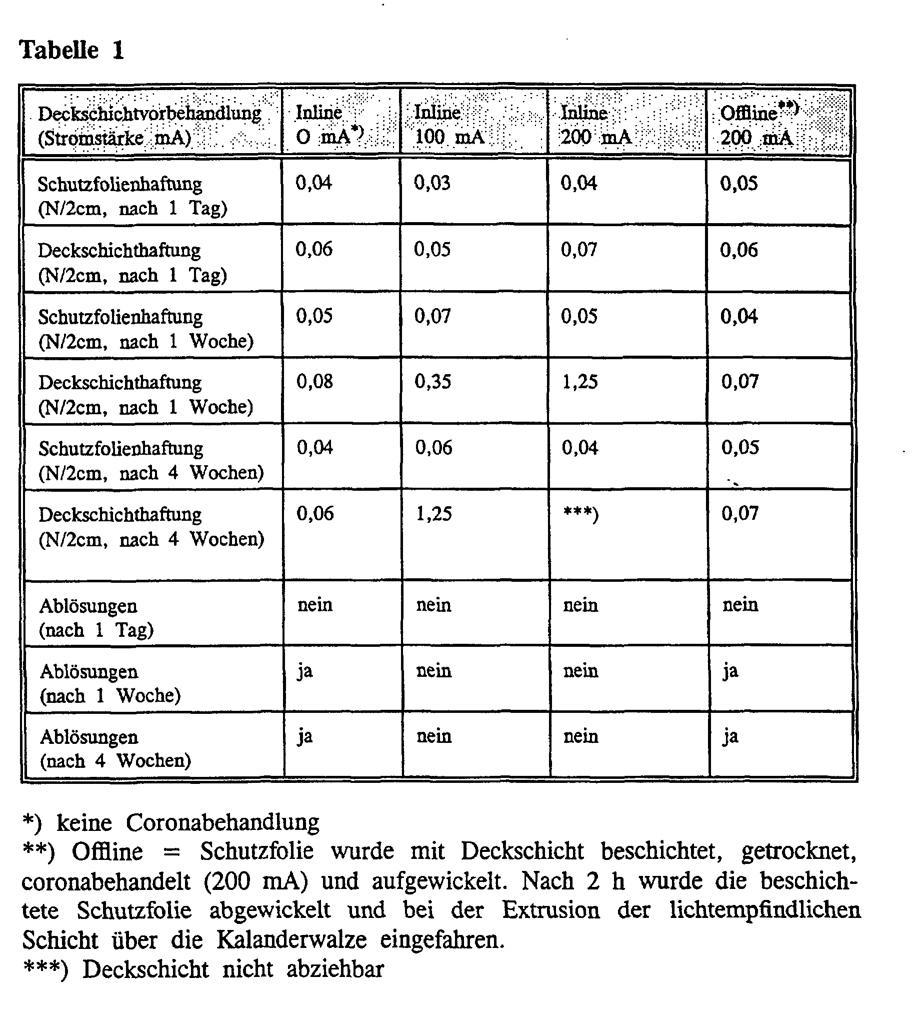

Die Ergebnisse waren in mehrfacher Hinsicht überraschend. Die Schutzfolienhaftung war niedrig. Die Werte schwankten zwischen 0,03 und 0,07 N/2cm und waren unabhängig von der Coronabehandlung. Die Deckschichthaftung war bei nicht coronabehandelten Platten nur wenig höher als die Schutzfolienhaftung. Die Werte lagen zwischen 0,06 und 0,08 N/2cm. Auch die coronabehandelten Platten hatten einen Tag nach Plattenherstellung keine höhere Deckschichthaftung. Erst nach einer Woche Lagerung zeigte sich die Wirkung der Coronabehandlung. Die Haftwerte stiegen mit der Stromstärke der Coronabehandlung an. Nach 4 Wochen Lagerung zeigte die mit 200 mA behandelte Platte das ideale Verhalten. Die Deckschichthaftung war so hoch, daß die Deckschicht nicht mehr von der lichtempfindlichen Schicht abgezogen werden konnte. Die Schutzfolienhaftung blieb dagegen auch bei Lagerung niedrig. Eine offline coronabehandelte Schutzfolie zeigte dagegen keinen Haftungsanstieg. Die Haftungsmessungen korrelierten mit den Ergebnissen des Praxistests. Direkt nach Herstellung konnte die Schutzfolie noch von allen Platten abgezogen werden, ohne daß sich die Deckschicht an den Kanten löste. Nach Lagerung zeigten die nicht behandelte Platte und die offline behandelte Platte starke Ablösungen. Die inline behandelten Flexodruckplatten funktionierten auch nach 1 und nach 4 Wochen Lagerung einwandfrei. Es wurden keinerlei Ablösungen der Deckschicht festgestellt.

Überraschend ist, daß die Wirkung der Inline-Coronabehandlung mit einer Zeitverzögerung auftritt, und, daß die Wirkung der Coronabehandlung nicht durch das Aufschmelzen der Polyamidschicht auf der Kalanderwalze zunichte gemacht wird.

### Beispiel 2

Ein Verbund aus einer 125 µm dicken Polyesterfolie wie in Beispiel 1 angegeben, einer 5 µm dicken Deckschicht aus Polyamid wie in Beispiel 1 und einer lichtempfindlichen Toplayerschicht wurde wie folgt hergestellt:

| Eine Lösung von | |
|---|---|
| 10,1 T | des in Beispiel 1 angegebenen Dreiblock-Copolymeren, |
| 4,7 T | eines Tetrapolymeren aus 46 % Methylmethacrylat, 9 % Acrylnitril, 14 % Butadien und 31 % Styrol und |
| 0,2 T | Acid Blue 92 (C.I. 13 390) in |
| 85 T | Methylenchlorid |

wurde auf die mit Deckschicht versehene Schutzfolie aus Polyester aufgegossen und getrocknet. Es wurde eine ca. 50 µm dicke Toplayer erhalten.

Eine lichtempfindliche Schicht der Zusammensetzung von Beispiel 1, jedoch ohne Zusatz von Sudanschwarz, wurde in einem Zweischneckenextruder verarbeitet und aus einer Breitschlitzdüse in den Spalt eines Zweiwalzenkalanders eingetragen. Beide Kalanderwalzen waren auf 80°C beheizt. Über die obere Kalanderwalze wurde eine mit Haftlack beschichtete 125 µm dicke Polyesterfolie eingeführt. Über die untere Kalanderwalze wurde der mehrschichtige Verbund aus Schutzfolie, Deckschicht und Toplayer eingeführt. Die Dicke des Kalanderspalts betrug 3,0 mm. Die entstehende mehrschichtige Druckplatte wurde mittels eines Vakuumsaugbandes abgezogen, abgekühlt und konfektioniert.

Zwischen der Zuführeinrichtung des mehrschichtigen Verbunds und der unteren Kalanderwalze befand sich die Coronabehandlungsanlage. Die Bahnbreite betrug 50 cm, die Geschwindigkeit 60 cm/min. Die Stromstärke der Coronabehandlung wurde von 0 über 100 bis 200 mA variiert. Die Toplayerseite des mehrschichtigen Verbunds wurde coronabehandelt. Anschließend wurde der Verbund zweimal umgelenkt (einmal mit Kontakt der Toplayer zur Umlenkwalze) und auf die Kalanderwalze geführt.

Nach einer Lagerzeit von einer Woche wurden aus den Druckplatten Klischees hergestellt. Folgende Verarbeitungsschritte wurden durchgeführt.
a) Rückseitige Vorbelichtung mit UV-Licht ohne Vorlage (F III Belichter BASF, 35 Sekunden),
b) Abziehen der Schutzfolie,
c) Auflegen eines nyloflex® FAR II Testfilms (BASF),
d) Hauptbelichtung unter Vakuumfolie (F III Belichter, Belichtungszeit 15 min),
e) Auswaschen der Platte (Durchlaufsystem VF III BASF, Durchlaufgeschwindigkeit 150 mm/min, Auswaschmittel nylosolv® II von BASF, 30°C, Relieftiefe 1000 µm),
f) 2 Stunden Trocknen bei 65°C,
g) Nachbelichtung (F III Belichter, 10 min),
h) Nachbehandeln mit UV-C-Licht (F III Nachbehandlungsgerät BASF, 10 min),

Weitere Klischees wurden hergestellt mit dem Unterschied, daß ca. 50 % beziehungsweise 100 % länger gewaschen wurde als erforderlich (Überwaschtest, Durchlaufgeschwindigkeit 100 beziehungsweise 75 mm/min). Die Testklischees wurden ausgewertet. Beurteilt wurde, ob die Testelemente (freistehender Punkt 200 µm, 50 µm Gitter und 2 % Rasterfeld 60 Linien/cm) auf dem Klischee korrekt mit Toplayer ausgebildet waren. Die Ergebnisse sind in Tabelle 2 zusammengefaßt.

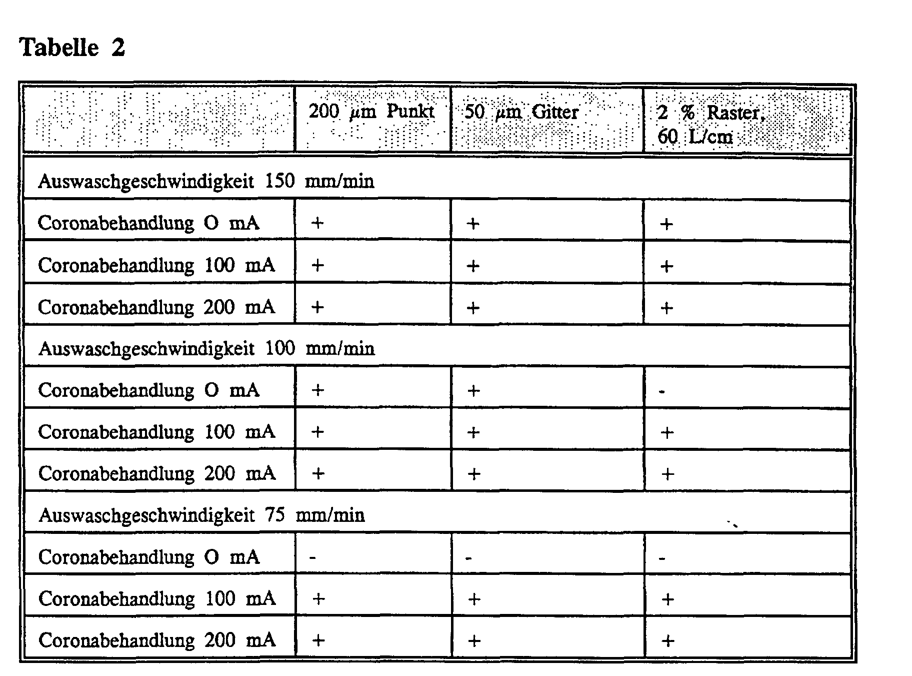

Aus Tabelle 2 wird ersichtlich, daß die Testelemente aller Platten bei optimaler Auswaschgeschwindigkeit korrekt ausgebildet waren. Wurden die Platten überwaschen, waren nur die Testelemente der coronabehandelten Platten korrekt ausgebildet. Bei den nicht coronabehandelten Platten fehlte die Toplayer ganz oder teilweise. Fazit: Eine Inline-Coronabehandlung der Toplayer verbessert die Haftung zwischen Toplayer und unterer lichtempfindlicher Schicht, wodurch die Überwaschempfindlichkeit der Platten verringert, also die Entwicklerresistenz erhöht wird.

### Beispiel 3

Beispiel 2 wurde wiederholt, mit der Änderung, daß bereits bei der Herstellung des mehrschichtigen Verbunds aus Schutzfolie/Deckschicht/Toplayer eine Inline-Coronabehandlung der Deckschicht durchgeführt wurde, bevor die Toplayerlösung aufgegossen wurde (Bahnbreite 50 cm, Bahngeschwindigkeit 60 cm/min, Stromstärke 200 mA).

Eine zweite Inline-Coronabehandlung wurde dann wie in Beispiel 2 bei der Herstellung der eigentlichen Druckplatte durchgeführt. Als Stromstärke wurden wiederum 200 mA gewählt.

Nach einer Ruhezeit von 1 Woche wurden die mehrschichtigen Flexodruckplatten geprüft. Die Deckschicht konnte nicht von der Toplayerschicht abgezogen werden. Beim Abziehen der Schutzfolie wurden keinerlei Ablösungen festgestellt. Die Klischees waren gegen Überwaschen sehr stabil. Auch bei einer um 100 % verlängerten Auswaschzeit wurden keine Ablösungen der Toplayer von der unteren lichtempfindlichen Schicht festgestellt.

## Patentansprüche

1. Verfahren zum Herstellen eines lichtempfindlichen Aufzeichnungsmaterials für die Herstellung von Reliefdruckplatten, bei dem eine lichtempfindliche Schicht mit einem Verbundelement aus einer Schutzfolie, einer Deckschicht und gegebenenfalls einer weiteren Schicht verbunden wird, **dadurch gekennzeichnet, daß** die lichtempfindliche Schicht als Schmelze auf das Verbundelement aufgebracht und die Oberfläche der obersten Schicht des Verbundelements 1 bis 3000 Sekunden vor dem Kontaktieren einer Coronabehandlung unterworfen wird.

2. Verfahren nach Anspruch 1, **dadurch gekennzeichnet, daß** die Coronabehandlung als eine Stufe eines kontinuierlichen Verfahrens durchlaufen wird.

3. Verfahren nach Anspruch 1 oder 2, **dadurch gekennzeichnet, daß** die Deckschicht des Verbundelementes dessen oberste Schicht ist und der Coronabehandlung unterworfen wird.

4. Verfahren nach Anspruch 1 oder 3, **dadurch gekennzeichnet, daß** auf die Deckschicht des Verbundelementes eine weitere Schicht aufgebracht wird, die lichtempfindlich ist oder vor dem Gebrauch der Druckplatte lichtempfindlich gemacht wird, und daß die Oberfläche dieser Schicht vor dem Verbinden mit der ersten lichtempfindlichen Schicht einer Coronabehandlung unterworfen wird.

5. Verfahren nach Anspruch 1, **dadurch gekennzeichnet, daß** die lichtempfindliche Schicht durch Extrudieren aus der Schmelze erzeugt und bei der Vereinigung mit dem Verbundelement zugleich an ihrer gegenüberliegenden Seite mit einem dimensionsbeständigen Schichtträger verbunden wird.

6. Verfahren nach Anspruch 5, **dadurch gekennzeichnet, daß** man die Oberfläche des dimensionsbeständigen Schichtträgers vor der Vereinigung mit der lichtempfindlichen Schicht ebenfalls einer Coronabehandlung unterwirft.

7. Verfahren nach Anspruch 1 oder 4, **dadurch gekennzeichnet, daß** die lichtempfindliche Schicht beziehungsweise die lichtempfindlichen Schichten photopolymerisierbare Schichten sind, die ein polymeres Bindemittel, eine ethylenisch ungesättigte, radikalisch polymerisierbare Verbindung und einen durch aktinische Strahlung aktivierbaren Polymerisationsinitiator enthalten.

8. Verfahren nach Anspruch 7, **dadurch gekennzeichnet, daß** als polymeres Bindemittel ein Elastomeres eingesetzt wird.

9. Verfahren nach Anspruch 1, **dadurch gekennzeichnet, daß** die Deckschicht aus einem Polyamid besteht.

## Claims

1. A process for the production of a photosensitive recording material for producing relief printing plates, in which a photosensitive layer is laminated with a composite element comprising a protective cover sheet, a release layer and optionally a further layer, **characterized in that** the photosensitive layer is applied as a melt to the composite element and the surface of the uppermost layer of the composite element is subjected to a corona treatment 1 to 3000 seconds before contact.

2. A process as claimed in claim 1, **characterized in that** the corona treatment is a stage in a continuous process.

3. A process as claimed in claim 1 or 2, **characterized in that** the release layer of the composite element is its uppermost layer and is subjected to the corona treatment.

4. A process as claimed in claim 1 or 3, **characterized in that** a further layer which is photosensitive or which is rendered photosensitive before the printing plate is used is applied to the release layer of the composite element, and the surface of said further layer is subjected to a corona treatment before being bonded to the first photosensitive layer.

5. A process as claimed in claim 1, **characterized in that** the photosensitive layer is produced by extrusion from the melt and, on combination with the composite element, is simultaneously bonded on its opposite side to a dimensionally stable substrate.

6. A process as claimed in claim 5, **characterized in that** the surface of the dimensionally stable substrate is likewise subjected to a corona treatment before combination with the photosensitive layer.

7. A process as claimed in claim 1 or 4, **characterized in that** the photosensitive layer or the photosensitive layers is or are a photopolymerizable layer or photopolymerizable layers which contains or contain a polymeric binder, an ethylenically unsaturated compound capable of free radical polymerization and a polymerization initiator which can be activated by actinic radiation.

8. A process as claimed in claim 7, **characterized in that** the polymeric binder used is an elastomer.

9. A process as claimed in claim 1, **characterized in that** the release layer consists of a polyamide.

## Revendications

1. Procédé pour la préparation d'un matériau d'enregistrement photosensible prévu lui-même pour la préparation de plaques d'impression en relief, dans lequel une couche photosensible est associée avec un élément combiné consistant en une feuille de protection, une couche de couverture et le cas échéant une autre couche, **caractérisé par le fait que** la couche photosensible est appliquée à l'état de masse fondue sur l'élément combiné et la surface de la couche supérieure de l'élément combiné est soumise à traitement corona pendant 1 à 3000 secondes avant la mise en contact.

2. Procédé selon la revendication 1, **caractérisé par le fait que** le traitement corona constitue un stade opératoire d'une opération continue.

3. Procédé selon la revendication 1 ou 2, **caractérisé par le fait que** la couche de couverture de l'élément combiné est sa couche supérieure et est soumise au traitement corona.

4. Procédé selon la revendication 1 ou 3, **caractérisé par le fait que**, sur la couche de couverture de l'élément combiné, on a appliqué une autre couche qui est photosensible ou est rendue photosensible avant utilisation de la plaque d'impression et **par le fait que** la surface de cette couche est soumise à un traitement corona avant la liaison avec la première couche photosensible.

5. Procédé selon la revendication 1, **caractérisé par le fait que** la couche photosensible est produite par extrusion à l'état fondu et **par le fait que**, lors de sa liaison avec l'élément combiné, elle est en même temps associée par sa face opposée à un support de couche à dimensions stables.

6. Procédé selon la revendication 5, **caractérisé par le fait que** la surface du support de couche à dimensions stables est également soumise à un traitement corona avant sa liaison avec la couche photosensible.

7. Procédé selon la revendication 1 ou 4, **caractérisé par le fait que** la couche photosensible ou les couches photosensibles sont des couches photopolymérisables qui contiennent un liant polymère, un composé à insaturation éthylénique apte à la polymérisation radicalaire et un inducteur de polymérisation activable par les rayonnements actiniques.

8. Procédé selon la revendication 7, **caractérisé par le fait que** le liant polymère utilisé est un élastomère.

9. Procédé selon la revendication 1, **caractérisé par le fait que** la couche de couverture consiste en un polyamide.
